# EUROPÄISCHE PATENTSCHRIFT

(11) **EP 1 039 638 B1**
(45) Veröffentlichungstag und Bekanntmachung des Hinweises auf die Patenterteilung: **12.11.2003**
(21) Anmeldenummer: 00104257.1
(22) Anmeldetag: 01.03.2000
(51) Int. Cl.: H03K 5/135, H03L 7/081

(54) **Schaltungsanordnung zum störungsfreien Initialisieren von Verzögerungsregelschleifen mit schneller Verriegelung**
Circuit for initialising fast-lock delay locked loop circuits without interference
Circuit pour l'initialisation, sans perturbation, de circuits de boucle à verrouillage de retard à verrouillage rapide

(30) Priorität: 11.03.1999 DE 19910885
(43) Veröffentlichungstag der Anmeldung: 27.09.2000
(73) Patentinhaber: Infineon Technologies AG, 81669 München (DE)
(72) Erfinder: Höhler, Rainer, Dr., 81739 München (DE); Von Borcke, Mathias, Dr., 81545 München (DE)
(74) Vertreter: Müller - Hoffmann & Partner

(56) Entgegenhaltungen:
- WO-A-98/37656
- KIM B -S ET AL: "A LOW POWER 100MHZ ALL DIGITAL DELAY-LOCKED LOOP" IEEE INTERNATIONAL SYMPOSIUM ON CIRCUITS AND SYSTEMS,US,NEW-YORK, NY: IEEE,1997, Seiten 1820-1823, XP000802928 ISBN: 0-7803-3584-8
- OKAJIMA Y ET AL: "DIGITAL DELAY LOCKED LOOP AND DESIGN TECHNIQUE FOR HIGH-SPEED SYNCHRONOUS INTERFACE" IEICE TRANSACTIONS ON ELECTRONICS,JP,INSTITUTE OF ELECTRONICS INFORMATION AND COMM. ENG. TOKYO, Bd. E79-C, Nr. 6, 1. Juni 1996 (1996-06-01), Seiten 798-807, XP000631489 ISSN: 0916-8524

## Beschreibung

Die vorliegende Erfindung betrifft eine Schaltungsanordnung zum störungsfreien Initialisieren von Delay-Locked-Loop-Schaltungen (DLL-Schaltungen) mit Fast-Lock (schneller Verriegelung).

In integrierten Schaltungen mit beispielsweise sogenanntem Rambus-Interface wird ein extern der integrierten Schaltung zugeführter Takt an zahlreichen Stellen benötigt. Dies setzt eine große Verstärkung für den extern zugeführten Takt voraus. Eine solche große Verstärkung ist aber zwangsläufig mit entsprechenden Verzögerungszeiten verknüpft. Daher wird bevorzugt aus einem externen Takt ein interner Takt generiert, der zeitlich verschoben in jeweils richtiger Phasenlage denjenigen Stellen der integrierten Schaltung zugeführt wird, die einen solchen Takt benötigen.

Die Umwandlung eines externen Taktes in einen internen Takt gewünschter Phasenlage ist also ein bei integrierten Schaltungen allgemein auftretendes Problem.

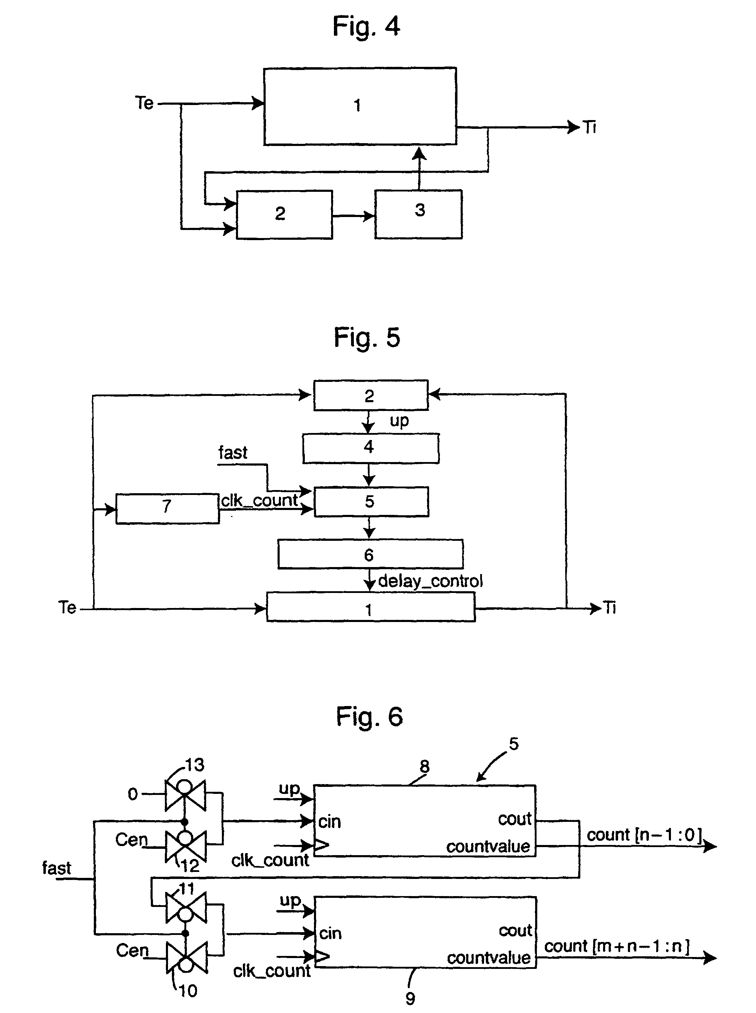

Fig. 4 zeigt in einem Blockschaltbild den Aufbau einer Schaltungsanordnung, mit der aus einem externen Takt Te ein interner Takt Ti gewonnen wird. Hierzu wird der externe Takt Te einer spannungsgesteuerten Verzögerungsleitung 1 zugeführt, die den mit dem externen Takt Te synchronisierten internen Takt Ti liefert. Hierzu ist die spannungsgesteuerte Verzögerungsleitung 1 durch ein Steuersignal so ansteuerbar, daß ihre Verzögerung variierbar ist. Dieses Steuersignal wird zweckmäßigerweise von einem Phasendetektor 2 und einem Filter 3 erzeugt. Durch den Phasendetektor 2 wird zunächst die Phase des internen Taktes Ti am Ausgang der spannungsgesteuerten Verzögerungsleitung 1 mit der Phase des externen Taktes Te an deren Eingang verglichen. Ein das Vergleichsergebnis darstellendes Signal wird dem Filter 3 zugeführt, der zweckmäßigerweise einen Tiefpaßanteil beinhaltet, um die Verzögerungszeit der spannungsgesteuerten Verzögerungsleitung 1 langsam auf die gewünschte Länge zu bringen.

Eine der Fig. 4 entsprechende Schaltungsanordnung ist in Einzelheiten beispielsweise in Stefanos Sidiropoulos und Mark A. Horowitz, A Semidigital Dual Delay-Locked-Loop, IEEE Journal of Solid-State Circuits, Band 32, Nr. 11, November 1997, Seiten 1683-1692, beschrieben.

Fig. 5 zeigt eine Schaltungsanordnung, die aus der aus der genannten Druckschrift bekannten Schaltungsanordnung abgeleitet ist. Im einzelnen ist in Fig. 5 eine DLL-Schaltung dargestellt, bei der der Ausgang des Phasendetektors 2, der zwischen dem Eingang und dem Ausgang der spannungsgesteuerten Verzögerungsleitung 1 liegt, über einen digitalen Tiefpaß 4, einen digitalen Zähler 5 und einen Digital/Analog-Konverter 6 mit dem Steuereingang der spannungsgesteuerten Verzögerungsleitung 1 verbunden ist. Der digitale Zähler 5 zählt abhängig von dem Pegel des Ausgangssignales des digitalen Tiefpaßfilters 4 aufwärts oder abwärts. Ein Taktsignal clk_count für den digitalen Zähler 5 wird aus dem hochfrequenten externen Taktsignal Te durch Herunterteilen dieses Taktsignales Te mittels eines Frequenzteilers 7 erzeugt, wodurch ein Tiefpaßverhalten für den digitalen Zähler 5 erreicht wird.

Der aktuelle Zählerstand des digitalen Zählers 5 wird mit Hilfe des Digital/Analog-Konverters 6 in ein analoges Steuersignal delay_control umgesetzt, das schließlich die Länge der spannungsgesteuerten Verzögerungsleitung 1 beeinflußt.

Um nun bei dieser Schaltungsanordnung die Zeit zum Einregeln der DLL während der Initialisierung zu verkürzen, wird ein Steuersignal "fast" eingeführt, das während der Initialisierung den digitalen Zähler 5 ansteuert. Außerdem wird die Initialisierung in zwei Phasen unterteilt: in einer ersten Phase ist das Signal "fast" aktiviert, während es in der zweiten Phase deaktiviert ist. Während der ersten Phase, in welcher das Steuersignal "fast" aktiviert ist, werden die niederwertigen Bits des digitalen Zählers 5 deaktiviert und direkt die höherwertigen Bits angesprochen.

Hierzu ist der digitale Zähler 5 in zwei Einheiten unterteilt, nämlich, wie in Fig. 6 gezeigt ist, in einen niederwertigen n-Bit-Zähler 8 und einen höherwertigen m-Bit-Zähler 9.

In der ersten Phase ist das Signal "fast" aktiviert, also auf einer logischen "1", so daß ein Transmissiongate 10 geöffnet ist, während Transmissiongates 11 und 12 gesperrt sind und ein Transmissiongate 13 ebenfalls geöffnet ist. Dadurch liegt ein Aktivierungssignal cen für die Zähler direkt über das Transmissiongate 10 an dem höherwertigen Zähler 9, während der niederwertige Zähler 8 deaktiviert ist.

Damit zählt infolge der Aktivierung des höherwertigen Zählers 9 der Zähler 5 im Vergleich zu einem normalen Betriebsmodus in deutlich größeren Schritten, und die DLL nähert sich schneller der gewünschten Ausgangsphase an. Wird anschließend in einer zweiten Phase das Steuersignal "fast" deaktiviert, also auf "0" gebracht, wird das Aktivierungssignal cen direkt auf den niederwertigen Zähler 8 über das Transmissiongate 12 geschaltet, und das Carry-Bit bzw. Übertrag-Bit "count" des niederwertigen Zählers 8 wird über das Transmissiongate 11 auf dem Carry-Eingang cin des höherwertigen Zählers 9 durchgeschaltet.

Dadurch sind alle Bits aktiviert, und der Zähler 5 zählt in entsprechend kleineren Schritten. Die DLL kann dann in höherer zeitlicher Auflösung die gewünschte Ausgangsphase einregeln.

Fig. 6 zeigt wie Fig. 5 auch die Takteingänge clk_count sowie Steuereingänge up für die Zählrichtung der Zähler 8, 9 und Ausgangsanschlüsse "countvalue" zur Lieferung von Ausgangssignalen count[n-1:0] für den Zähler bzw. count[m+n-1:n] für den Zähler 9.

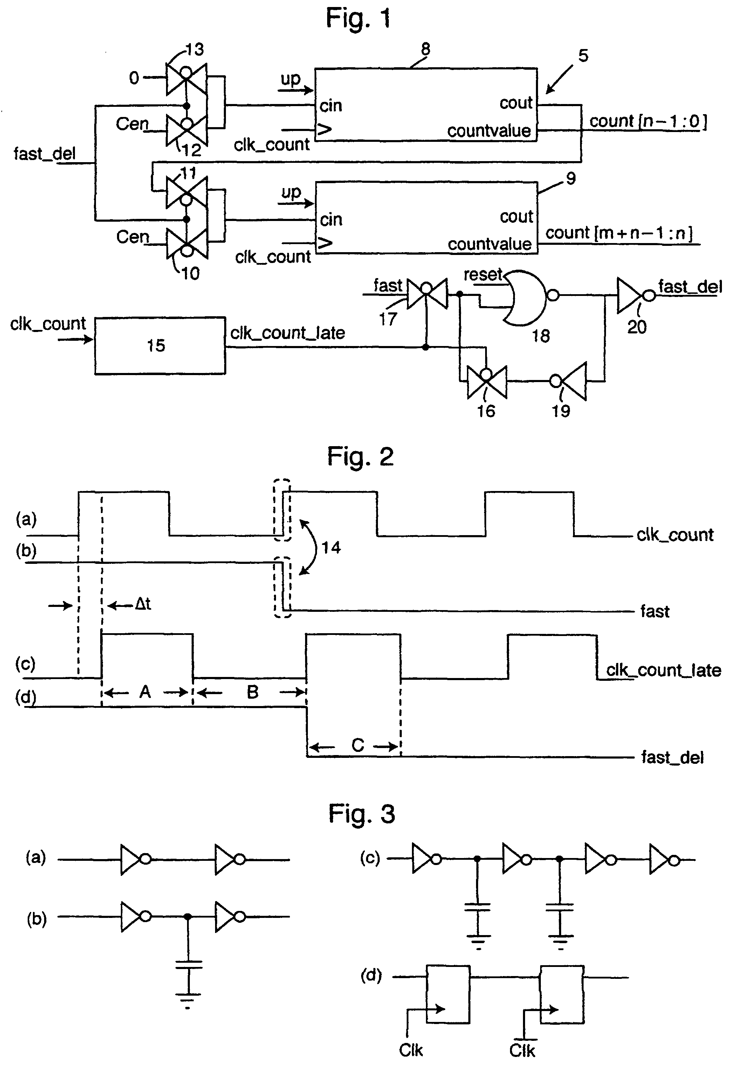

Bei der in den Fig. 5 und 6 gezeigten bestehenden Schaltungsanordnung treten nun Probleme auf, wenn das Steuersignal "fast" zu einem beliebigen Zeitpunkt deaktiviert wird. Fig. 2(a) zeigt den Verlauf des Taktsignales clk_count, während in Fig. 2(b) das Steuersignal "fast" dargestellt ist, wie es bei der bestehenden Schaltungsanordnung gezeigt ist. Fällt nun die Deaktivierung des Steuersignales "fast" zeitlich nahezu oder ganz mit einer Änderung des Pegels des Taktsignales zusammen, wie dies in Fig. 2 durch einen Doppelpfeil 14 angedeutet ist, so können Instabilitäten im Zählerwert countvalue auftreten, was die gesamte DLL in einen Zustand bringt, in der sie nicht mehr die gewünschte Phasenlage des internen Taktes Ti einzuregeln vermag.

Es ist daher Aufgabe der vorliegenden Erfindung, eine Schaltungsanordnung zum störungsfreien Initialisieren von DLL-Schaltungen mit Fast-Lock anzugeben, bei der Instabilitäten von Zählerwerten infolge der Deaktivierung eines Zähler-Steuersignales vermieden werden.

Diese Aufgabe wird mit einer Schaltungsanordnung mit den Merkmalen gemäß Anspruch 1 gelöst.

Bei der erfindungsgemäßen Schaltungsanordnung wird also das Steuersignal "fast", dessen abfallende Flanke an sich zu einem beliebigen Zeitpunkt auftreten kann, in ein verzögertes Steuersignal überführt, dessen Flanke nun zu einem Zeitpunkt auftritt, in welchem keine Instabilitäten des Zählers entstehen können. Hierzu wird zunächst ein verzögertes Taktsignal für den Zähler erzeugt, mit dem das Steuersignal kurz nach der ansteigenden Flanke des Taktsignales übernommen wird. Bei fallender Flanke des verzögerten Taktsignales für den Zähler wird das verzögerte Steuersignal bis zum nächsten Abtastzeitpunkt konstant gehalten. Dadurch wird erreicht, daß das verzögerte Steuersignal konstant gehalten wird, während es Einfluß auf das Zähler-Ausgangssignal nehmen kann, also während der steigenden Flanke des Taktsignales. Mit anderen Worten, mit der erfindungsgemäßen Schaltungsanordnung kann ein stabiler Betrieb des Zählers gewährleistet werden.

Die erfindungsgemäße Schaltungsanordnung erzeugt so zunächst mittels einer Verzögerungsschaltung eine verzögerte "Kopie" des Zähler-Taktsignales. Das Steuersignal für den Zähler wird mit diesem verzögerten Taktsignal abgetastet, und die abfallende Flanke des so verzögerten Steuersignales wird in einen für den Zählerbetrieb unkritischen Zeitbereich verlegt.

Für die Verzögerungsschaltung können in vorteilhafter Weise Inverterstufen, die gegebenenfalls mit kapazitiven Lasten versehen sind, wobei die letzte Inverterstufe lastfrei sein sollte, oder auch Flipflops verwendet werden, welche mit einem hinreichend hochfrequenten Takt angesteuert werden.

Nachfolgend wird die Erfindung anhand der Zeichnungen näher erläutert. Es zeigen:
- Fig. 1: ein Ausführungsbeispiel der erfindungsgemäßen Schaltungsanordnung,
- Fig. 2: den Verlauf von Signalen bei einer bestehenden Schaltungsanordnung (Fig. 2(a) und (b)) und bei der erfindungsgemäßen Schaltungsanordnung (Fig. 2(c) und (d)),
- Fig. 3(a) bis (c): mögliche Gestaltungen für eine Verzögerungsschaltung,
- Fig. 4: ein Blockschaltbild zur Erläuterung einer bestehenden Schaltungsanordnung,
- Fig. 5: ein detailliertes Blockschaltbild für die Schaltungsanordnung von Fig. 4 und
- Fig. 6: den digitalen Zähler 5 von Fig. 5 in Einzelheiten.

Die Fig. 4 bis 6 sowie 2(a) und (b) sind bereits eingangs erläutert worden. In den Figuren werden für einander entsprechende Bauteile jeweils die gleichen Bezugszeichen verwendet. Auch werden für das Ausführungsbeispiel der Fig. 1 Bauteile, die dem bestehenden Zähler von Fig. 6 entsprechen, nicht mehr näher beschrieben.

Fig. 1 zeigt ein Ausführungsbeispiel der erfindungsgemäßen Schaltungsanordnung, bei der zusätzlich zu der Schaltungsanordnung von Fig. 6 (und Fig. 5) noch eine Verzögerungsschaltung 15 vorgesehen ist, die aus dem Taktsignal clk_count ein verzögertes Taktsignal clk_count_late erzeugt, das die gleiche Frequenz wie das Taktsignal clk_count besitzt, jedoch zeitlich zu diesem verzögert ist, so daß es etwas später auftritt. Dieses verzögerte Taktsignal wird zu einem bei logischer "0" offenen Transmissiongate 16 und einem bei anliegender logischer "1" offenem Transmissiongate 17 gespeist, wobei dieses Transmissiongate 17 im Signalpfad des Steuersignales "fast" liegt. Der Ausgang des Transmissiongates 17 ist über ein NOR-Gatter 18 bzw. das Transmissiongate 16 und einen Inverter 19 mit dem Eingang eines Inverters 20 verbunden, an dessen Ausgang ein verzögertes Steuersignal "fast_del" erhalten wird. Bei dieser Schaltungsanordnung wird das Taktsignal clk_count_late dazu verwendet, das Steuersignal "fast" transparent auf das verzögerte Steuersignal "fast_del" durchzuschalten, während das verzögerte Taktsignal clk_count_late auf "1" bzw. hoch steht und das verzögerte Steuersignal "fast_del" konstant zu halten, während das verzögerte Taktsignal clk_count_late auf 0 bzw. niedrig steht.

Mit anderen Worten, das verzögerte Taktsignal clk_count_late nimmt den um Δt verzögerten und in Fig. 2(c) gezeigten Verlauf bezüglich des Taktsignales clk_count an, während das verzögerte Steuersignal "fast_del" erst in einem unkritischen Zeitbereich auf einen niedrigen Zustand übergeht, nachdem es zunächst während einer Zeitspanne A entsprechend dem Steuersignal auf "1" ist und dieser Zustand während eines Zeitraumes B beibehalten wird. In einem Zeitraum C übernimmt das verzögerte Steuersignal wieder den Verlauf des Steuersignales "fast" und behält diesen anschließend bei, usw.

Da nach einem Rücksetzen grundsätzlich in einem Modus gearbeitet wird, bei welchem das Steuersignal "fast" in einem hohen Zustand ist, ist mit dem Gatter 18 ein Setzen des verzögerten Steuersignales "fast_del", während "reset" (bzw. Rücksetzen) = hoch integriert.

Fig. 3 zeigt verschiedene Ausführungsbeispiele für die Gestaltung der Verzögerungsschaltung 15. Diese kann beispielsweise aus der Reihenschaltung von einer geradzahligen Anzahl von Invertern (Fig. 3(a)) bestehen, die mit einer kapazitiven Last zwischen den Invertern versehen sein können (Fig. 3(b)), wobei die letzte Inverterstufe nicht belastet sein sollte (Fig. 3(c)). Ebenso ist es möglich, anstelle der Inverter die Verzögerungsschaltung 15 mit Hilfe einer digitalen Schaltung aus Flipflops zu realisieren, die mit einem hinreichend hochfrequenten Takt clk angesteuert wird (Fig. 3(d)).

## Patentansprüche

1. Schaltungsanordnung zum störungsfreien Initialisieren von Delay-Locked-Loop-Schaltungen (DLL-Schaltungen) mit Fast-Lock, bei der
- ein chipinterner Takt (Ti) auf einen externen Takt (Te) mittels einer über einen Phasendetektor (2), einen Filter (3), eine Zählereinrichtung (5) und einen Digital/Analog-Konverter (6) angesteuerten Verzögerungsleitung (1) synchronisiert ist, und
- die Zählereinrichtung (5) aus wenigstens einem höherwertigen Zähler (9) und einem niederwertigen Zähler (8) besteht, die jeweils durch ein Zähler-Taktsignal (clk_count) ansteuerbar sind und alternativ mittels eines aus einem Steuersignal (fast) erzeugten verzögerten Steuersignales (fast del) aktivierbar und deaktivierbar sind, um die Zeit zum Einregeln der DLL zu verkürzen, wobei:
- eine Verzögerungsschaltung (15) aus dem Zähler-Taktsignal (clk_count) ein verzögertes Taktsignal (clk_count_late) erzeugt und bei einem hohen Pegel des verzögerten Taktsignales (clk_count_late) das Steuersignal (fast) unverändert in das verzögerte Steuersignal (fast del) überführt sowie bei einem niedrigen Pegel des verzögerten Taktsignales (clk_count_del) das unmittelbar vor dessen fallender Flanke anliegende Steuersignal (fast) hält.

2. Schaltungsanordnung nach Anspruch 1,
**dadurch gekennzeichnet, dass** der Verzögerungsschaltung (15) der Steuereingang eines Transmissiongates (17) nachgeschaltet ist, an dessen Eingang das Steuersignal (fast) liegt.

3. Schaltungsanordnung nach Anspruch 2,
**dadurch gekennzeichnet, dass** der Verzögerungsschaltung (15) der Steuereingang eines weiteren Transmissiongates (16) nachgeschaltet ist, das zwischen dem Ausgang des Transmissiongates (17) und einem Inverter (19) liegt.

4. Schaltungsanordnung nach Anspruch 3,
**dadurch gekennzeichnet, dass** dem Transmissiongate (17) ein NOR-Gatter (18) nachgeschaltet ist, dessen Ausgang mit einem Verbindungspunkt zwischen dem Inverter (19) und einem weiteren Inverter (20) verbunden ist.

5. Schaltungsanordnung nach einem der Ansprüche 1 bis 4,
**dadurch gekennzeichnet, dass** die Verzögerungsschaltung (15) aus Invertern besteht (Fig. 3(a)).

6. Schaltungsanordnung nach Anspruch 5,
**dadurch gekennzeichnet, dass** die Inverter mit einer kapazitiven Last versehen sind (Fig. 3(b)).

7. Schaltungsanordnung nach Anspruch 6,
**dadurch gekennzeichnet, dass** eine letzte Inverterstufe ohne kapazitive Last ist (Fig. 3(c)).

8. Schaltungsanordnung nach einem der Ansprüche 1 bis 4, **dadurch gekennzeichnet, dass** die Verzögerungsschaltung aus Flipflops aufgebaut ist (Fig. 3(d)).

## Claims

1. Circuit arrangement for interference-free initialization of delay locked loop circuits (DLL circuits) with fast lock, in which
- a chip-internal clock (Ti) is synchronized to an external clock (Te) by means of a delay line (1) which is driven via a phase detector (2), a filter (3), a counter device (5) and a digital/analogue converter (6), and
- the counter device (5) comprises at least one high-value counter (9) and one low-value counter (8), which can each be driven by a counter clock signal (clk_count) and, alternatively, can be activated and deactivated by means of a delayed control signal (fast del) which is produced from a control signal (fast), in order to shorten the time for the DLL to lock in, with:
- a delay circuit (15) producing a delayed clock signal (clk_count_late) from the counter clock signal (clk_count) and, if the delayed clock signal (clk_count_late) is at a high level, converting the control signal (fast) without any change to the delayed control signal (fast del) and, if the delayed clock signal (clk_count_del) is at a low level, maintaining the control signal (fast) which was present immediately before its falling flank.

2. Circuit arrangement according to Claim 1,
**characterized in that**
the delay circuit (15) is followed by the control input of a transmission gate (17), to whose input the control signal (fast) is applied.

3. Circuit arrangement according to Claim 2,
**characterized in that**
the delay circuit (15) is followed by the control input of a further transmission gate (16), which is connected between the output of the transmission gate (17) and an inverter (19).

4. Circuit arrangement according to Claim 3,
**characterized in that**
the transmission gate (17) is followed by a NOR gate (18), whose output is connected to a junction point between the inverter (19) and a further inverter (20).

5. Circuit arrangement according to one of Claims 1 to 4,
**characterized in that**
the delay circuit (15) comprises inverters (Figure 3(a)).

6. Circuit arrangement according to Claim 5,
**characterized in that**
the inverters are provided with a capacitive load (Figure 3(b)).

7. Circuit arrangement according to Claim 6,
**characterized in that**
a final inverter stage has no capacitive load (Figure 3(c)).

8. Circuit arrangement according to one of Claims 1 to 4,
**characterized in that**
the delay circuit is formed from flipflops (Figure 3(d)).

## Revendications

1. Montage d'initialisation, sans perturbations, de circuits Delay-Looked-Loop (circuits DLL) à verrouillage rapide, dans lequel
- une cadence d'horloge (Ti) intérieure à la puce est synchronisée sur une cadence d'horloge (Te) extérieure au moyen d'une ligne (1) de retard commandée par un détecteur (2) de phase, par un filtre (3), par un dispositif (5) de comptage et par un convertisseur (6) numérique/analogique, et
- le dispositif (5) de comptage est constitué d'au moins un compteur (9) d'ordre supérieur et d'un compteur (8) d'ordre inférieur qui sont commandés, respectivement, par un signal d'horloge de compteur (clk_count) et qui peuvent être activés et désactivés en alternance au moyen d'un signal de commande retardé (fast del) produit à partir d'un signal de commande (fast) pour raccourcir la durée de réglage du DLL, dans lequel :
- un circuit (15) de retard produit un signal d'horloge retardé (clk_count_late) à partir du signal d'horloge de compteur (clk_count) et, pour un niveau haut du signal d'horloge retardé (clk_count_late), modifie le signal de commande (fast) et le transforme en le signal de commande retardé (fast del) ainsi que, pour un niveau bas du signal d'horloge retardé (clk_count_del), maintient le signal de commande (fast) s'appliquant directement avant son front descendant.

2. Montage suivant la revendication 1, **caractérisé en ce qu'**il est monté en aval du circuit (15) de retard l'entrée de commande d'une porte (17) de transmission à l'entrée de laquelle s'applique le signal de commande (fast).

3. Montage suivant la revendication 2, **caractérisé en ce qu'**il est monté en aval du circuit (15) de retard l'entrée de commande d'une autre porte (16) de transmission qui est interposée entre la sortie de la porte (17) de transmission et un inverseur (19).

4. Montage suivant la revendication 3, **caractérisé en ce qu'**il est monté en aval de la porte (17) de transmission une porte (18) NON OU dont la sortie est reliée à un point de liaison entre l'inverseur (19) et un autre inverseur (20).

5. Montage suivant l'une des revendications 1 à 4, **caractérisé en ce que** le circuit (15) de retard est constitué d'inverseurs (Figure 3(a)).

6. Montage suivant la revendication 5, **caractérisé en ce que** les inverseurs sont munis d'une charge capacitive (Figure 3(b)).

7. Montage suivant la revendication 6, **caractérisé en ce qu'**un dernier étage d'inverseur est sans charge capacitive (Figure 3(c)).

8. Montage suivant l'une des revendications 1 à 4, **caractérisé en ce que** le circuit de retard est constitué de bascules (Figure 3(d)).
